# EUROPEAN PATENT APPLICATION

(11) **EP 4 807 745 A1**
(43) Date of publication of application: **16.09.2026**
(21) Application number: 24902539.6
(22) Date of filing: 25.11.2024
(51) Int. Cl.: G11C 16/12

(54) **NAND FLASH MEMORY, MEMORY AND ELECTRONIC DEVICE**

(30) Priority: 12.12.2023 CN 202311706589
(71) Applicant: Huawei Technologies Co., Ltd., Shenzhen, Guangdong 518129 (CN)
(72) Inventor: ZHANG, Qi, Shenzhen, Guangdong 518129 (CN); LI, Nan, Shenzhen, Guangdong 518129 (CN); QI, Guangtian, Shenzhen, Guangdong 518129 (CN); HUANG, Chen, Shenzhen, Guangdong 518129 (CN)
(74) Representative: Gill Jennings & Every LLP
(86) International application number: PCT/CN2024/134142
(87) International publication number: WO 2025/124117

(57) **Abstract**

A NAND memory, a memory, and an electronic device are provided. When a NAND memory simultaneously reads data of a plurality of pages within a same plane, saturation currents of the pages and/or durations for reading the data of the pages may be different, so that the data recorded by the pages is different, a total current of a read circuit varies, and a voltage drop rate of a discharge capacitor C_{SO} varies. When the NAND memory reads the data of the plurality of pages, a voltage comparison unit may be used to detect a relationship between a voltage of the discharge capacitor C_{SO} and a comparison voltage, to accurately read the data recorded by the pages, thereby preventing confusion between the read data and the pages.

## Description

This application claims priority to Chinese Patent Application No. 202311706589.2, filed with the China National Intellectual Property Administration on December 12, 2023 and entitled "NAND MEMORY, MEMORY, AND ELECTRONIC DEVICE", which is incorporated herein by reference in its entirety.

### TECHNICAL FIELD

This application relates to the field of storage chip technologies, and in particular, to a NAND memory, a memory, and an electronic device.

### BACKGROUND

A not and (not and, NAND) flash memory is a non-volatile storage device that uses a NAND gate circuit to store data. The NAND memory has advantages such as high storage density, fast data read/write speed, low power consumption, and long service life, and can be widely used in various electronic devices such as solid-state disks (solid-state disks, SSDs), universal serial bus (universal serial bus, USB) flash drives, memory cards, and mobile devices.

Data reading and writing are the most typical scenarios in NAND memory applications. Among them, data reading (read operation) is the most important use scenario for users. Therefore, it is significant to improve read performance and reduce power consumption for the NAND memory. The read operation of the NAND memory can be divided into a precharge phase, an evaluate phase, and a discharge phase. The latency of each phase is continuously reduced with improvement in manufacturing process, circuit design, and manufacturing capability until the latency reaches an extreme value. As NAND memory media are iteratively updated, the reduction in read latency gradually slows down, causing a failure for the NAND memory to meet future storage scenario requirements for low power consumption and high performance.

### SUMMARY

To resolve the foregoing problems, embodiments of this application provide a NAND memory, a memory, and an electronic device. When data of a plurality of pages is read within a same plane, saturation currents of the pages and/or durations for reading the data of the pages are different, so that the data recorded by the pages can be accurately read, thereby preventing confusion between the read data and the pages. In addition, this application further provides a memory and an electronic device that correspond to the NAND memory.

Therefore, the following technical solutions are used in embodiments of this application.

According to a first aspect, an embodiment of this application provides a NAND memory, including: a voltage control unit, including a plurality of first output ports and a plurality of second output ports, where the plurality of first output ports are all configured to output a first electrical signal, and the plurality of second output ports are all configured to output a second electrical signal; a NAND array, including a plurality of strings, where each string includes a plurality of pages, and the plurality of pages are electrically connected to the plurality of first output ports respectively and configured to read or write data when the first electrical signal is received; an asynchronous unit, electrically connected between the plurality of first output ports and the plurality of strings, or electrically connected to gates of string selectors in the plurality of pages of the plurality of strings and gates of dual-gate MOS transistors in the plurality of pages of the plurality of strings, configured to, when data of target dual-gate MOS transistors of the plurality of pages is simultaneously read, cause saturation currents of the target dual-gate MOS transistors of the plurality of simultaneously read pages to be different, and/or cause conduction times of respective pages among the plurality of simultaneously read pages to be different; a plurality of discharge capacitors C_{SO}, where first terminals of the plurality of discharge capacitors are electrically connected to the plurality of second output ports respectively, and second terminals of the plurality of discharge capacitors are grounded; and a voltage comparison unit, including a plurality of input ports, where the plurality of input ports are electrically connected to the plurality of second output ports respectively, configured to compare voltages received at the plurality of input ports with a comparison voltage and output comparison results.

In this implementation, when the NAND memory simultaneously reads the data of the plurality of pages within the same plane, the saturation currents of the pages and/or durations for reading the data of the pages may be different, so that the data recorded by respective pages is different, a total current of a read circuit varies, and a voltage drop rate of the discharge capacitor C_{SO} varies. When the NAND memory reads the data of the plurality of pages, the voltage comparison unit may be used to detect a relationship between a voltage of the discharge capacitor C_{SO} and a comparison voltage, to accurately read the data recorded by the pages, thereby preventing confusion between the read data and the pages.

In an implementation, the discharge capacitor is in a discharging state when data recorded by a target dual-gate MOS transistor of a page electrically connected to the discharge capacitor is "1"; and the discharge capacitor is in a charging state when the data recorded by the target dual-gate MOS transistor of the page electrically connected to the discharge capacitor is "0".

In this implementation, when the data recorded by the target dual-gate MOS transistor is "1", a circuit in which the target dual-gate MOS transistor and the discharge capacitor are located is turned on, and the discharge capacitor may discharge to decrease a voltage of the discharge capacitor. When the data recorded by the target dual-gate MOS transistor is "0", the circuit in which the target dual-gate MOS transistor and the discharge capacitor are located is turned off, and the discharge capacitor may be in the charging state to maintain the voltage of the discharge capacitor. The voltage comparison unit may accurately read the data recorded by the pages based on voltages of the plurality of discharge capacitors at different moments, thereby preventing confusion between the read data and the pages.

In an implementation, the voltage comparison unit is specifically configured to compare voltages received at the plurality of input ports at a plurality of latch (latch) time points with the comparison voltage to obtain a plurality of output sub-results; and the NAND memory further includes: a decoding unit, configured to compare the plurality of output sub-results with a preset result, and determine whether the data recorded by the target dual-gate MOS transistors of the respective pages among the plurality of simultaneously read pages is "0" or "1", where the preset result records that output sub-results of different latch time points correspond to data recorded by a plurality of simultaneously read target dual-gate MOS transistors.

In this implementation, because the saturation currents of the target dual-gate MOS transistors of the plurality of simultaneously read pages are different or the times for reading the data of the pages are different, the voltage comparison unit determines that voltages of the plurality of discharge capacitors are different at different moments. The decoding unit may compare, based on a pre-stored table of the decoding unit, the data recorded by the target dual-gate MOS transistors that corresponds to the voltages of the plurality of discharge capacitors at different moments, to accurately read the data recorded by the pages, thereby preventing confusion between the read data and the pages.

In an implementation, a relationship between a quantity M of the plurality of latch time points and a quantity N of simultaneously read pages is: M≥(2^{N}-1); and M and N are positive integers greater than or equal to 2.

In this implementation, the quantity M of latch time points set by the voltage comparison unit should not be less than (2^{N}-1). This avoids an insufficient quantity of latch time points, which results in incapability of distinguishing between the voltages of the plurality of discharge capacitors when the data recorded by the target dual-gate MOS transistors of the plurality of simultaneously read pages is different.

In an implementation, there is at least one latch time point between different discharge durations, and the discharge duration refers to a duration for a voltage of a discharge capacitor electrically connected to the target dual-gate MOS transistors of the plurality of simultaneously read pages to decrease to the comparison voltage.

In an implementation, when the conduction times of the respective pages among the plurality of simultaneously read pages are different, a time difference between conduction times of two adjacent pages is less than or equal to duration for which the voltage of the discharge capacitor decreases to the comparison voltage.

In this implementation, when the asynchronous unit enables the times for reading the data of the pages to be different, a delayed time is less than or equal to the duration in which the voltage of the discharge capacitor decreases to the comparison voltage, to avoid completely asynchronous reading of two pages.

In an implementation, the voltage control unit is further configured to: when stopping output of the first electrical signal and the second electrical signal, electrically connect the plurality of first output ports to the plurality of second output ports respectively.

In this implementation, after stopping output of the first electrical signal and the second electrical signal, the voltage control unit may electrically connect each first output port to one second output port to form a read loop, and enable the discharge capacitor C_{SO} to discharge, to read data.

In an implementation, the voltage control unit is further configured to convert a current at the second output ports from a first value to a second value.

In this implementation, after the plurality of first output ports are electrically connected to the plurality of second output ports respectively, the voltage control unit may change current values of the second output ports, to reduce the currents flowing into the NAND array 420, thereby protecting the NAND array.

According to a second aspect, an embodiment of this application provides a memory, including: a circuit board and at least one NAND memory according to the possible implementations of the first aspect, where the NAND memory is electrically fastened to the circuit board, and is configured to store data.

According to a third aspect, an embodiment of this application provides an electronic device, including at least one memory according to the possible implementations of the second aspect and at least one processor, where the processor is electrically connected to the at least one memory and configured to write data to the at least one memory and/or read data from the at least one memory.

### BRIEF DESCRIPTION OF DRAWINGS

The following briefly describes accompanying drawings that need to be used in descriptions of embodiments or the conventional technology.
FIG. 1 is a diagram of a structure of a dual-gate MOS transistor of a NAND memory in a related technology;
FIG. 2 is a diagram of a structure of a NAND memory in a related technology;
FIG. 3 is a diagram of a path for a NAND memory to read data of a page 1 of a string 0 in a related technology;
FIG. 4 is a diagram of a structure of a first NAND memory according to an embodiment of this application;
FIG. 5 is a diagram of a relationship between a voltage drop rate and a current of a discharge capacitor C_{SO} in a read circuit according to an embodiment of this application;
FIG. 6 is a diagram of a structure of a second NAND memory according to an embodiment of this application;
FIG. 7 is a diagram of a relationship between a voltage drop rate and a current of a discharge capacitor C_{SO} in a read circuit according to an embodiment of this application; and
FIG. 8 is a diagram of a structure of a third NAND memory according to an embodiment of this application.

### DESCRIPTION OF EMBODIMENTS

The following describes the technical solutions in embodiments of this application with reference to the accompanying drawings in embodiments of this application.

The term "and/or" in this specification describes an association relationship between associated objects and represents that three relationships may exist. For example, A and/or B may represent the following three cases: Only A exists, both A and B exist, and only B exists. The character "/" in this specification indicates an "or" relationship between the associated objects. For example, A/B indicates A or B.

In the specification and claims of this application, the terms "first", "second", and the like are intended to distinguish between different objects, but do not indicate a particular order of the objects. For example, a first response message, a second response message, and the like are used to distinguish between different response messages, but do not indicate a particular order of the response messages.

In addition, in embodiments of this application, the word "exemplary" or "for example" is used to represent giving an example, an illustration, or a description. Any embodiment or design scheme described as an "example" or "for example" in embodiments of this application should not be explained as being more preferred or having more advantages than another embodiment or design scheme. To be precise, use of the terms such as "example" or "for example" is intended to present a relative concept in a specific manner.

In descriptions of embodiments of this application, unless otherwise specified, "a plurality of" means two or more. For example, a plurality of processing units mean two or more processing units, and a plurality of elements mean two or more elements.

A NAND memory uses a dual-gate transistor design. A conventional metal-oxide-semiconductor field-effect transistor (metal-oxide-semiconductor field-effect transistor, MOSFET) includes a source (source), a drain (drain), a gate (gate), and a body (body). A floating gate is added to an insulation layer of a conventional MOS transistor for a memory cell inside the NAND memory to store a charge. A large voltage difference is applied between the gate and the body, so that electrons or holes can be injected into the floating gate to implement write and erase operations. An amount of stored charges affects a threshold voltage V_{TH} of a transistor. Different threshold voltages V_{TH} represent different stored information states. Therefore, each memory cell stores data of one or more (bit) bits. When a voltage applied to the gate is greater than the threshold voltage V_{TH}, a channel inversion occurs. If there is a voltage difference between the source and the drain in this case, a current path is formed. Otherwise, there is no current path. Based on this, a value of the threshold voltage V_{TH} of the transistor may be determined, that is, the stored data may be read.

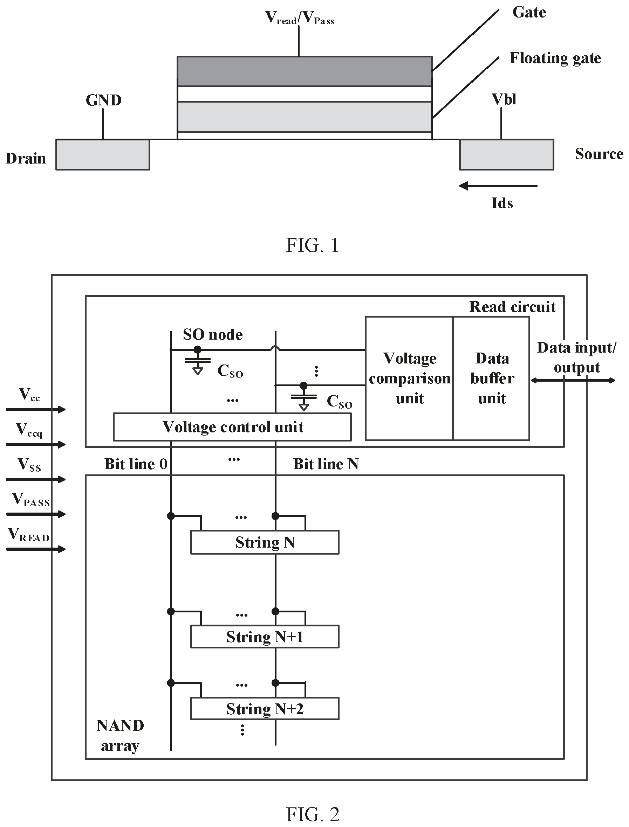

FIG. 1 is a diagram of a structure of a dual-gate MOS transistor of a NAND memory in a related technology. As shown in FIG. 1, the NAND memory may change a threshold voltage V_{TH} of the dual-gate MOS transistor by using an amount of charge stored on the floating gate. After the NAND memory applies a read voltage V_{read} to the gate, if the read voltage V_{read} is greater than the threshold voltage V_{TH} formed by the charges in the floating gate, a controllable transconductance effect in the dual-gate MOS transistor is triggered, so that a channel between the source and the drain is turned on, and a current passes through the channel. When the read voltage V_{read} is greater than the threshold voltage V_{TH}, and the dual-gate MOS transistor of the memory cell is in an on state, it represents that data recorded by the memory cell is "1". On the contrary, when the read voltage V_{read} is less than the threshold voltage V_{TH}, and the dual-gate MOS transistor of the memory cell is in an off state, it represents that data recorded by the memory cell is "0".

In the NAND memory, a read operation is performed in a unit of "page (page)". One page usually includes a plurality of memory cells (cell). When the NAND memory performs the read operation, a word line (word line, WL) of a target page is selected first, and the WL is connected to a source output (source output, SO) node by using a bit line (bit line, BL).

As shown in FIG. 2, the NAND memory includes a read circuit, and a voltage control unit of the read circuit applies a proper read voltage V_{read} to the BL. After a voltage is applied to the BL, a state of charge of a memory cell affects the voltage on the BL. If a threshold voltage V_{TH} formed by the state of charge of the memory cell is greater than the read voltage V_{read} on the BL, the read voltage V_{read} on the BL changes. The read circuit amplifies and encodes a changed voltage based on a change of the read voltage V_{read} on the BL, and outputs data information in a detected manner. Therefore, the NAND memory can quickly read and transmit data in the memory cell by detecting a voltage change of a discharge capacitor C_{SO}.

A process in which the NAND memory reads a single page may be divided into a precharge phase (precharge phase), an evaluate phase (evaluate phase), and a discharge phase (discharge phase).

In the precharge phase, a voltage control unit charges the WL and the BL, so that a voltage formed at the BL and a voltage formed by the discharge capacitor C_{SO} at the SO node are V_{BL} and V_{SO}, and V_{BL}<V_{SO}.

In the evaluate phase, the voltage V_{SO} of the discharge capacitor C_{SO} at the SO node is greater than the voltage V_{BL} at the BL. If the memory cell is in the on state (data is "1"), the discharge capacitor Cso discharges until the voltage Vso of the discharge capacitor Cso is less than a comparison voltage V_{THSA}. If the memory cell is in the off state (data is "0"), the discharge capacitor C_{SO} does not discharge, and the voltage V_{SO} of the discharge capacitor C_{SO} is always greater than the comparison voltage V_{THSA}. A voltage comparison unit inside the NAND memory may obtain the voltage V_{SO} of the discharge capacitor C_{SO} at the SO node at a "latch (latch)" time point, and determine whether the read data is "1" or "0" by comparing the voltage V_{SO} with the comparison voltage V_{THSA}. The voltage comparison unit saves and stores the read data in a data temporary storage area.

In the discharge phase, the voltage control unit discharges the WL and the BL to complete this time of read operation.

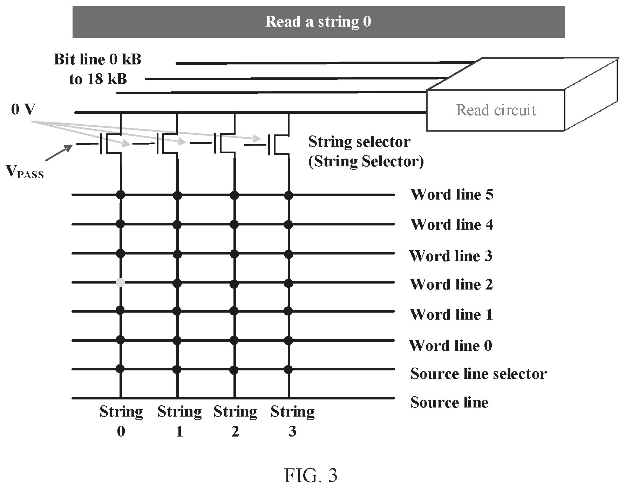

Within the same plane (plane), the NAND memory needs to serially read data of a plurality of pages. As shown in FIG. 3, reading data of a page 1 of a string (string) 0 is used as an example. When the NAND memory needs to read a target memory cell, a row address decoder performs processing, and voltages output by a boost and voltage control circuit are applied to the WLs. A positive voltage Vpass is applied to a string selector to turn on the string selector, so that the BL can access a memory cell under the string 0. In addition, another non-selected string selector is set at a low voltage (for example, 0 V), to prevent the non-selected string selector from being turned on, and avoid interference with a read result.

After the read voltage V_{read} is applied to a WL2 in which the target memory cell is located, a memory cell on the WL2 may be activated and selected for reading. A gate of another memory cell is set to a high voltage Vₚₐₛₛ, so that a transistor connected in series with the another string is turned on, to ensure that the on state of the entire string is determined based on the on state of the read memory cell. If data written into the target memory cell is "0", it represents that the threshold voltage V_{TH} of the target memory cell is greater than the read voltage V_{read}, the target memory cell is in the off state, and a memory cell string almost has no current passing through. If data written into the target memory cell is "1", it represents that the threshold voltage V_{TH} of the target memory cell is greater than the read voltage V_{read}, the target memory cell is in the on state, a memory cell string has a current passing through, and the current is I_{cell}. After reading the page 1, the NAND memory discharges the WL and BL. If the NAND memory needs to read a page on a string 1, the foregoing procedure is repeated, and only a string selector 0 needs to be turned off and a string selector 1 needs to be turned on.

When the NAND memory performs the read operation, different planes and different logical unit numbers (logical unit number, LUN) may operate independently. This means that in one NAND memory chip, a plurality of planes and a plurality of LUNs can perform the read operation simultaneously. Within the same plane, different pages may be read in a serial reading manner. Serial reading means reading pages one by one in sequence rather than reading a plurality of pages simultaneously. When the NAND memory reads one page, the BL needs to be charged and discharged again to read data. However, repeated charging and discharging processes limit read performance and increase read power consumption. If two strings are turned on simultaneously, currents passing through the two strings are close to the same, and decreasing slopes of the voltages V_{SO} at the node SO are close to the same. In this case, two cases "01" and "10" may not be distinguished, and consequently, confusion occurs between the read data and the pages.

To resolve disadvantages in a related technology, embodiments of this application provide a new NAND memory, a memory, and an electronic device. An asynchronous unit may be added to the NAND memory to improve a data read speed. The asynchronous unit may enable saturation currents of pages to be different, enable durations for reading data of pages to be different, or enable both saturation currents of pages and durations for reading data of the pages to be different. When the NAND memory simultaneously reads data of a plurality of pages within the same plane, saturation currents of the pages and/or durations for reading the data of the pages may be different, so that the data recorded by the pages is different, a total current of a read circuit varies, and a voltage drop rate of the discharge capacitor C_{SO} varies. When the NAND memory reads the data of the plurality of pages, a voltage comparison unit may be used to detect relationships between the voltages of the discharge capacitor C_{SO} at a plurality of latch time points and a comparison voltage, to accurately read the data recorded by the pages, thereby preventing confusion between the read data and the pages. The asynchronous unit may also be referred to as a "current limiting unit", a "time control unit", and a "current limiting and time control unit" below based on functions of the asynchronous unit.

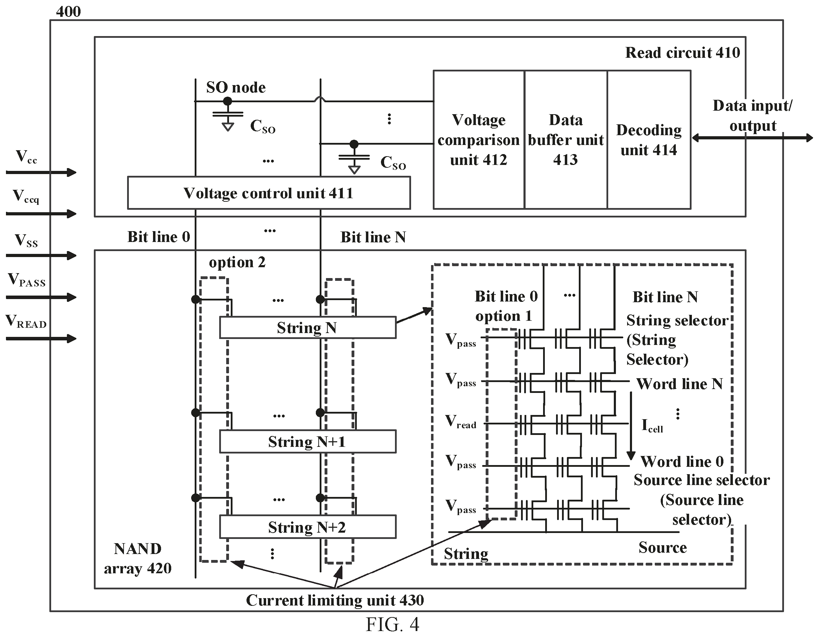

FIG. 4 is a diagram of a structure of a first NAND memory according to an embodiment of this application. As shown in FIG. 4, the NAND memory 400 includes a read circuit 410, a NAND array 420, and a current limiting unit 430. A CMOS circuit 410 includes a voltage control unit 411, a voltage comparison unit 412, a data buffer unit 413, a decoding unit 414, and a plurality of discharge capacitors C_{SO}. The NAND array 420 includes a plurality of strings.

The voltage control unit 411 includes a plurality of first output ports and a plurality of second output ports. The plurality of first output ports are respectively connected to the strings of the NAND array 420 by using lines, and the lines between the voltage control unit 411 and the plurality of strings are "BLs". Each string includes a plurality of string selectors, a drain of each string selector is connected to one BL, and a source of each string selector is connected in series with dual-gate MOS transistors of a plurality of memory cells. A gate of the dual-gate MOS transistor of each memory cell is connected to an external read unit by using a line, and the line between the gate of the dual-gate MOS transistor of each memory cell and the external read unit is "WL".

The plurality of second output ports of the voltage control unit 411 are respectively connected to a plurality of input ports of the voltage comparison unit 412. One terminal of each of the plurality of discharge capacitors C_{SO} is connected to a line between the second output port of the voltage control unit 411 and the input port of the voltage comparison unit 412, and the other terminal of each of the plurality of discharge capacitors C_{SO} is grounded. A node at which the discharge capacitor C_{SO} is connected to the line between the second output port of the voltage control unit 411 and the input port of the voltage comparison unit 412 is an SO node.

The voltage control unit 411 is configured to convert electric energy provided by a power supply into a proper voltage, and finely regulate voltages applied to the WL, for example, a read voltage V_{read} and a pass voltage Vₚₐₛₛ, to provide a voltage for the BL, the WL, and the discharge capacitor C_{SO}. In a process in which the NAND memory 400 reads data, the voltage control unit 411 charges the discharge capacitor C_{SO} and controls a voltage at the SO node in the precharge phase, and may stop supplying power in the evaluate phase, so that a line in which one SO node is located is connected to one BL to form a read loop, and the voltage at the SO node can be clamped, thereby preventing the voltage of the SO node from being excessively low.

In this embodiment of this application, a voltage applied by the voltage control unit 411 to the BLs of the NAND array 420 is VBL, and a voltage applied to the input ports of the voltage comparison unit 412 of the read circuit 410 is VSO, where VSO>VBL. After the plurality of first output ports are electrically connected to the plurality of second output ports respectively, the voltage control unit 411 may change current values of the second output ports, to convert a current at the second output ports from a first value to a second value. The voltage control unit 411 changes a current when the discharge capacitor C_{SO} discharges, and reduces a current flowing into the NAND array 420, thereby protecting the NAND array 420.

The read circuit 410 may further include a read unit. The read unit is configured to parse an input address signal, and determine an index, a page, a string, or other location information of a target memory cell that needs to be operated. The read unit transmits the location information obtained through parsing to the NAND array 420, so that a string selector in a corresponding string in the NAND array 420 is turned on, and a circuit in which the target memory cell is located is turned on. In addition, the address decoding unit 413 is further configured to generate a proper operation signal based on the location information obtained through parsing and a selection result of the target memory cell, to control charging and discharging, erasing, or another related operation of the target memory cell.

In this embodiment of this application, when the NAND array 420 simultaneously performs a read operation on memory cells managed by more than one string, the read unit may simultaneously parse more than one piece of input address information, transmit more than one location obtained through parsing to the NAND array 420, and control a select gate of more than one target memory cell.

The current limiting unit 430 may be disposed between the BLs and the strings, or disposed between gates of string selectors in the strings and gates of dual-gate MOS transistors of the memory cells, and is configured to regulate and control gate voltages, threshold voltages, values of series resistances, values of equivalent resistances, and the like of the dual-gate MOS transistors of the memory cells of the pages, to limit saturation currents of the pages, so that the saturation currents of the pages are different. The saturation current refers to a current in a read circuit in which dual-gate MOS transistors of memory cells of a page, a string selector in which the page is located, a BL, and a discharge capacitor C_{SO} are located.

For example, the NAND memory 400 simultaneously reads data of memory cells of two pages, and the two pages are respectively a page 0 and a page 1. It is assumed that the memory cell of the page 0 is connected to a string selector 0 and a BL0, the memory cell of the page 1 is connected to a string selector 1 and a BL1, and a saturation current I_{cell0} of a dual-gate MOS transistor of the memory cell of the page 0 is greater than a saturation current I_{cell1} of a dual-gate MOS transistor of the memory cell of the page 1.

In the evaluate phase, if the data of the memory cell of the page 0 is "1" and the data of the memory cell of the page 1 is "1", the dual-gate MOS transistor of the memory cell of the page 0 is in an on state and a current flowing through a channel between a source and a drain in the dual-gate MOS transistor is the saturation current I_{cell0}, and the dual-gate MOS transistor of the memory cell of the page 1 is in an on state and a current flowing through a channel between a source and a drain in the dual-gate MOS transistor is the saturation current I_{cell1}. Therefore, when data is "11", a total current on the read circuit is I_{cell0}+ I_{cell1}.

If the data of the memory cell of the page 0 is "1" and the data of the memory cell of the page 1 is "0", the dual-gate MOS transistor of the memory cell of the page 0 is in an on state and a current flowing through a channel between a source and a drain in the dual-gate MOS transistor is the saturation current I_{cell0}, and the dual-gate MOS transistor of the memory cell of the page 1 is in an off state and a current flowing through a channel between a source and a drain in the dual-gate MOS transistor is 0. Therefore, when data is "10", a total current on the read circuit is I_{cell0}.

If the data of the memory cell of the page 0 is "0" and the data of the memory cell of the page 1 is "1", the dual-gate MOS transistor of the memory cell of the page 0 is in an off state and a current flowing through a channel between a source and a drain in the dual-gate MOS transistor is 0, and the dual-gate MOS transistor of the memory cell of the page 1 is in an on state and a current flowing through a channel between a source and a drain in the dual-gate MOS transistor is the saturation current I_{cell1}. Therefore, when data is "01", a total current on the read circuit is I_{cell1}.

If the data of the memory cell of the page 0 is "0" and the data of the memory cell of the page 1 is "0", the dual-gate MOS transistor of the memory cell of the page 0 is in an off state and a current flowing through a channel between a source and a drain in the dual-gate MOS transistor is 0, and the dual-gate MOS transistor of the memory cell of the page 1 is in an off state and a current flowing through a channel between a source and a drain in the dual-gate MOS transistor is 0. Therefore, when data is "00", a total current on the read circuit is 0.

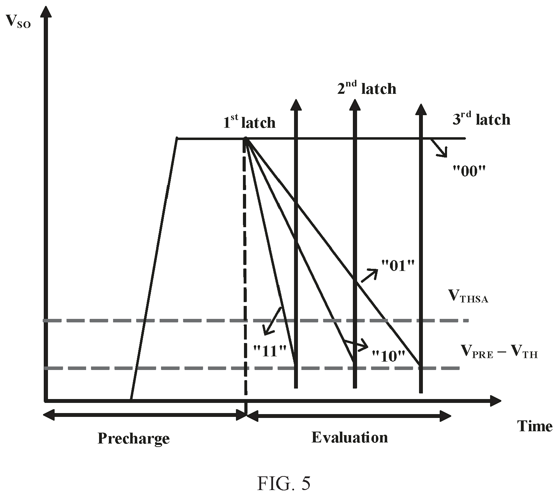

In this embodiment of this application, when the total current on the read circuit varies, a decreasing slope of a voltage of the discharge capacitor C_{SO} from a voltage V_{SO} to a comparison voltage V_{THSA} varies. As shown in FIG. 5, there are four cases of the total current on the read circuit: I_{cell0}+ I_{cell1}, I_{cell0}, I_{cell1}, and 0. When the data is "11", the total current on the read circuit is I_{cell0}+ I_{cell1}, and a voltage drop rate of the discharge capacitor C_{SO} is the fastest, and the slope is also the largest. Because the saturation current I_{cell0} is greater than the saturation current I_{cell1}, the voltage drop rate of the discharge capacitor C_{SO} when the data is "10" is greater than the voltage drop rate of the discharge capacitor C_{SO} when the data is "01", that is, a voltage change slope of the discharge capacitor C_{SO} when the data is "10" is greater than a voltage change slope of the discharge capacitor C_{SO} when the data is "01". When the total current on the read circuit is 0 when the data is "00", the voltage of the discharge capacitor C_{SO} remains unchanged.

The voltage comparison unit 412 is configured to receive a discharge capacitor voltage V_{SO} of the discharge capacitor C_{SO}, and compare the discharge capacitor voltage V_{SO} with the comparison voltage V_{THSA}. In this embodiment of this application, the voltage comparison unit 412 may set M latch time points. A relationship between a quantity M of the plurality of latch time points and a quantity N of simultaneously read pages is: M≥(2^{N}-1); and M and N are positive integers greater than or equal to 2.

The NAND memory 400 may be divided into a single-level cell (single level cell, SLC), a multi-level cell (multi-level cell, MLC), a triple-level cell (triple-level cell, TLC), a quad-level cell (quad-level cell, QLC), or the like based on a quantity of bits (bit) stored in a memory cell.

The SLC is a flash memory type. Each memory cell can store only one bit (0 or 1). When reading data of one page, the SLC applies the read voltage V_{read} to the memory cell once. Therefore, the relationship between the quantity M of latch time points set by the voltage comparison unit 412 and the quantity N of simultaneously read pages is: M≥(2^{N}-1).

Each memory cell of the MLC may store a plurality of bits, usually two bits. When reading data of one page, the MLC applies X1 read voltages V_{read} to the memory cell. Therefore, the relationship between the quantity M of latch time points set by the voltage comparison unit 412 and the quantity N of simultaneously read pages is: M≥(2^{N}-1)×X1. X1 is 1 or 2. A value of X1 is related to a type of a read page.

Each memory cell of the TLC may store more bits, usually three bits. When reading data of one page, the TLC applies X2 read voltages V_{read} to the memory cell. Therefore, the relationship between the quantity M of latch time points set by the voltage comparison unit 412 and the quantity N of simultaneously read pages is: M≥(2^{N}-1)×X2. X2 is 1, 2, 3, or 4. A value of X2 is related to a type of a read page.

Each memory cell of the QLC may store more bits, usually four bits. When reading data of one page, the QLC applies X3 read voltages V_{read} to the memory cell. Therefore, the relationship between the quantity M of latch time points set by the voltage comparison unit 412 and the quantity N of simultaneously read pages is: M≥(2^{N}-1)×X3. X3 is 1, 2, 3, 4, 5, 6, 7, or 8. A value of X3 is related to a type of a read page.

The voltage comparison unit 412 is configured to compare the voltage V_{SO} at the SO node with a specific comparison voltage V_{THSA} within a specific time, and digitize and latch a result. In this embodiment of this application, the voltage comparison unit 412 may detect a comparison result of each latch time point, and input the comparison result to the data buffer unit 413. In one case, when determining that a discharge capacitor voltage V_{SO} at a latch time point is greater than the comparison voltage V_{THSA}, the voltage comparison unit 412 outputs "fail". In another case, when determining that a discharge capacitor voltage V_{SO} at a latch time point is equal to or less than the comparison voltage V_{THSA}, the voltage comparison unit 412 outputs "pass".

There is at least one latch time point between different discharge durations. The discharge duration refers to a duration for a voltage of a discharge capacitor electrically connected to target dual-gate MOS transistors of a plurality of simultaneously read pages to decrease to the comparison voltage. Preferably, a first latch time point in the M latch time points may be set to a time point at which the voltage of the discharge capacitor C_{SO} when the data is "11" decreases to the comparison voltage V_{THSA}. An M^{th} latch time point in the M latch time points may be set to a time point at which the voltage of the discharge capacitor C_{SO} when the data is "01" decreases to the comparison voltage V_{THSA}. A second latch time point to an (N-1)^{th} latch time point in the M latch time points are between the first latch time point and the M^{th} latch time point.

As shown in FIG. 5, the voltage comparison unit 412 sets three latch time points. The first latch time point may be set to a time point at which the voltage of the discharge capacitor C_{SO} when the data is "11" decreases to the comparison voltage V_{THSA}. The second latch time point may be set to a time point at which the voltage of the discharge capacitor C_{SO} when the data is "10" decreases to the comparison voltage V_{THSA}. The third latch time point may be set to a time point at which the voltage of the discharge capacitor C_{SO} when the data is "01" decreases to the comparison voltage V_{THSA}.

Results output by the voltage comparison unit 412 are shown in Table 1. When the data is "11", the voltage comparison unit 412 outputs "pass" at the first latch time point, outputs "pass" at the second latch time point, and outputs "pass" at the third latch time point. When the data is "10", the voltage comparison unit 412 outputs "fail" at the first latch time point, outputs "pass" at the second latch time point, and outputs "pass" at the third latch time point. When the data is "01", the voltage comparison unit 412 outputs "fail" at the first latch time point, outputs "fail" at the second latch time point, and outputs "pass" at the third latch time point. When the data is "00", the voltage comparison unit 412 outputs "fail" at the first latch time point, outputs "fail" at the second latch time point, and outputs "fail" at the third latch time point.

**Table 1 Results output by the voltage comparison unit for different data at three latch time points**

| Page 0 | Page 1 | First latch | Second latch | Third latch |
|---|---|---|---|---|
| 1 | 1 | pass | pass | pass |
| 1 | 0 | fail | pass | pass |
| 0 | 1 | fail | fail | pass |
| 0 | 0 | fail | fail | fail |

The data buffer unit 413 is coupled to the voltage comparison unit 412, and is configured to store results latched a plurality of times by the voltage comparison unit 412, and perform data transmission with the decoding unit 414. In this embodiment of this application, the data buffer unit 413 temporarily buffers the data that is read from the NAND array 420 by the NAND memory 400, to subsequently transmit the read data to a host or a processor. The decoding unit 414 is coupled to the data buffer unit 413, and is configured to read the comparison results of the voltage comparison unit 412 buffered by the data buffer unit 413, and analyze, based on the comparison results, that the data of the pages is "0" or "1".

The decoding unit 414 is configured to perform an operation and processing on the results latched a plurality of times by the data buffer unit 413, to obtain original data of the read memory cells. In this embodiment of this application, the decoding unit 414 pre-stores a preset result in Table 1, and may define a case that when comparison results of the three latch time points are all "pass", the data of the page 0 is "1", and the data of the page 1 is "1". The NAND memory 400 may define a case that when the comparison result of the first latch time point is "fail", and the comparison results of the second latch time point and the third latch time point are "pass", the data of the page 0 is "1", and the data of the page 1 is "0". The NAND memory 400 may define a case that when the comparison results of the first latch time point and the second latch time point are "fail", and the comparison result of the third latch time point is "pass", the data of the page 0 is "0", and the data of the page 1 is "1". The NAND memory 400 may define a case that when the comparison results of the three latch time points are all "fail", the data of the page 0 is "0", and the data of the page 1 is "0".

If the three results received are all "pass", the decoding unit 414 outputs the data "11". If the first result received is "fail", and the second result and the third result are "pass", the decoding unit 414 outputs the data "10". If the first result and the second result received are "fail", and the third result is "pass", the decoding unit 414 outputs the data "01". If the three results received are all "fail", the decoding unit 414 outputs the data "00". Alternatively, if "pass" is considered as logic "1" and "fail" is considered as logic "0", a result of a first page is obtained through a logical OR operation of results latched for the first time and the second time, and a result of the second page is obtained through a logical OR operation of results latched for the first time and the third time.

In this embodiment of this application, when the NAND memory 400 simultaneously reads a plurality of pages within the same plane, a saturation current of a dual-gate MOS transistor of a memory cell of each page may be changed, so that the saturation currents of the pages are different. In this way, the data recorded by the pages is different, the total current of the read circuit varies, and the voltage drop rate of the discharge capacitor C_{SO} varies. When the NAND memory 400 reads the data of the plurality of pages, the voltage comparison unit may be used to detect relationships between the voltages of the discharge capacitor C_{SO} at a plurality of latch time points and the comparison voltage, to accurately read the data recorded by the pages, thereby preventing confusion between the read data and the pages.

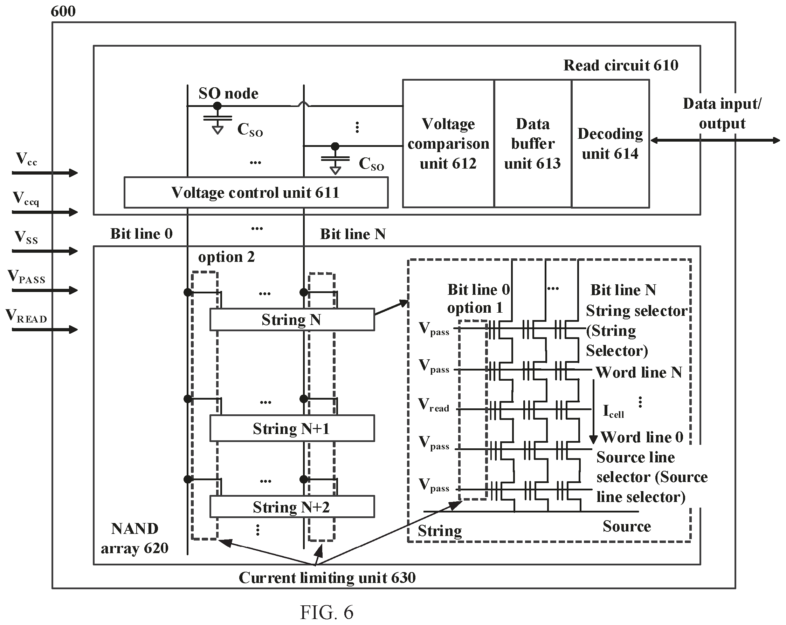

FIG. 6 is a diagram of a structure of a second NAND memory according to an embodiment of this application. As shown in FIG. 6, compared with the structure of the NAND memory 400, in a structure of the NAND memory 600, the current limiting unit 430 is replaced with a time control unit 630.

The time control unit 630 is configured to stagger discharging times of pages, for example, in a manner of changing an application time of the read voltage V_{read}, or adjusting, by adding an additional switch, times at which different pages start to enter the evaluate phase, so that memory cells of the pages start to enter the evaluate phase and read data at different moments. In this embodiment of this application, the time control unit 630 may be connected to string selectors, and send a control signal to the string selectors, to turn on the string selectors, so that data of memory cells of pages corresponding to different strings is read at different moments. Optionally, a switch transistor may be disposed on each WL in the NAND memory 600. The time control unit 630 is separately connected to the switch transistors, and sends the control signal to the switch transistors to turn on the switch transistors, so that data of memory cells of different pages is read at different moments.

For example, the NAND memory 400 simultaneously reads data of memory cells of two pages, and the two pages are respectively a page 0 and a page 1. It is assumed that the memory cell of the page 0 is connected to a string selector 0 and a BL0, and the memory cell of the page 1 is connected to a string selector 1 and a BL1. Saturation currents I_{cell} of dual-gate MOS transistors of the memory cells of the two pages are the same, and a difference between times for applying the read voltage V_{read} to the dual-gate MOS transistors of the memory cells of the two pages is set time T. Duration of the set time T is equal to or less than a time for reading the data of the memory cell of the page 0.

In the evaluate phase, the time control unit 630 preferentially enables the string selector in which the page 0 is located to be turned on, and after the set time T, enables the string selector in which the page 1 is located to be turned on. If the data of the memory cell of the page 0 is "1" and the data of the memory cell of the page 1 is "1", the dual-gate MOS transistor of the memory cell of the page 0 is in an on state and a current flowing through a channel between a source and a drain in the dual-gate MOS transistor is the saturation current I_{cell}, and the dual-gate MOS transistor of the memory cell of the page 1 is in an on state and a current flowing through a channel between a source and a drain in the dual-gate MOS transistor is the saturation current I_{cell}. Therefore, when data is "11", a total current on the read circuit changes from I_{cell} to 2I_{cell} after the time T.

If the data of the memory cell of the page 0 is "1" and the data of the memory cell of the page 1 is "0", the dual-gate MOS transistor of the memory cell of the page 0 is in an on state and a current flowing through a channel between a source and a drain in the dual-gate MOS transistor is the saturation current I_{cell}, and the dual-gate MOS transistor of the memory cell of the page 1 is in an off state and a current flowing through a channel between a source and a drain in the dual-gate MOS transistor is 0. Therefore, when data is "10", a total current on the read circuit is always I_{cell}.

If the data of the memory cell of the page 0 is "0" and the data of the memory cell of the page 1 is "1", the dual-gate MOS transistor of the memory cell of the page 0 is in an off state and a current flowing through a channel between a source and a drain in the dual-gate MOS transistor is 0, and the dual-gate MOS transistor of the memory cell of the page 1 is in an on state and a current flowing through a channel between a source and a drain in the dual-gate MOS transistor is the saturation current I_{cell}. Therefore, when data is "01", a total current on the read circuit changes from 0 to I_{cell} after the time T.

If the data of the memory cell of the page 0 is "0" and the data of the memory cell of the page 1 is "0", the dual-gate MOS transistor of the memory cell of the page 0 is in an off state and a current flowing through a channel between a source and a drain in the dual-gate MOS transistor is 0, and the dual-gate MOS transistor of the memory cell of the page 1 is in an off state and a current flowing through a channel between a source and a drain in the dual-gate MOS transistor is 0. Therefore, when data is "00", a total current on the read circuit is always 0.

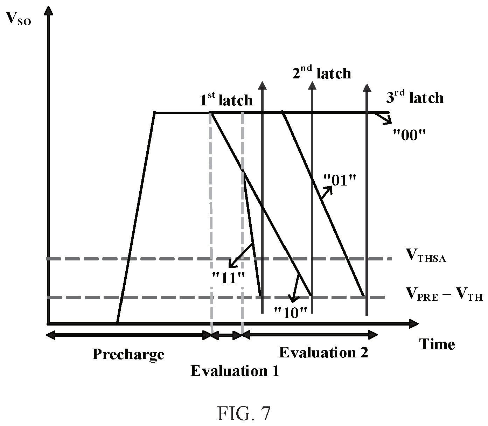

When the total current on the read circuit varies, a decreasing slope of a voltage of the discharge capacitor C_{SO} from a voltage V_{SO} to a comparison voltage V_{THSA} varies. As shown in FIG. 7, when the total current on the read circuit is I_{cell} when the data is "11", a voltage drop rate of the discharge capacitor C_{SO} is fast, and a slope is also large. When the total current on the read circuit becomes 2I_{cell} when the data is "11", the voltage drop rate of the discharge capacitor C_{SO} increases, and the slope increases based on the original one. When the data is "10", the total current on the read circuit is always I_{cell}. Therefore, the voltage drop rate of the discharge capacitor C_{SO} remains unchanged, and the slope also remains unchanged. When the total current on the read circuit is 0 when the data is "01", the voltage of the discharge capacitor CSO remains unchanged. When the total current on the read circuit becomes I_{cell} when the data is "01", the voltage of the discharge capacitor C_{SO} starts to decrease, and the drop rate is the same as the voltage drop rate of the discharge capacitor C_{SO} when the data is "10", and the slope is also the same. When the total current on the read circuit is 0 when the data is "00", the voltage of the discharge capacitor C_{SO} remains unchanged.

The voltage comparison unit 612 sets three latch time points. The first latch time point may be set to a time point at which the voltage of the discharge capacitor C_{SO} when the data is "11" decreases to the comparison voltage V_{THSA}. The second latch time point may be set to a time point at which the voltage of the discharge capacitor C_{SO} when the data is "10" decreases to the comparison voltage V_{THSA}. The third latch time point may be set to a time point at which the voltage of the discharge capacitor C_{SO} when the data is "01" decreases to the comparison voltage VTHSA.

Results output by the voltage comparison unit 612 are shown in Table 2. When the data is "11", the voltage comparison unit 612 outputs "pass" at the first latch time point, outputs "pass" at the second latch time point, and outputs "pass" at the third latch time point. When the data is "10", the voltage comparison unit 612 outputs "fail" at the first latch time point, outputs "pass" at the second latch time point, and outputs "pass" at the third latch time point. When the data is "01", the voltage comparison unit 612 outputs "fail" at the first latch time point, outputs "fail" at the second latch time point, and outputs "pass" at the third latch time point. When the data is "00", the voltage comparison unit 612 outputs "fail" at the first latch time point, outputs "fail" at the second latch time point, and outputs "fail" at the third latch time point.

**Table 2 Results output by the voltage comparison unit for different data at three latch time points**

| Page 0 | Page 1 | First latch | Second latch | Third latch |
|---|---|---|---|---|
| 1 | 1 | pass | pass | pass |
| 1 | 0 | fail | pass | pass |
| 0 | 1 | fail | fail | pass |
| 0 | 0 | fail | fail | fail |

The decoding unit 614 pre-stores a preset result in Table 2, and may define a case that when comparison results of the three latch time points are all "pass", the data of the page 0 is "1", and the data of the page 1 is "1". The NAND memory 600 may define a case that when the comparison result of the first latch time point is "fail", and the comparison results of the second latch time point and the third latch time point are "pass", the data of the page 0 is "1", and the data of the page 1 is "0". The NAND memory 600 may define a case that when the comparison results of the first latch time point and the second latch time point are "fail", and the comparison result of the third latch time point is "pass", the data of the page 0 is "0", and the data of the page 1 is "1". The NAND memory 600 may define a case that when the comparison results of the three latch time points are all "fail", the data of the page 0 is "0", and the data of the page 1 is "0".

If the three results received are all "pass", the decoding unit 614 outputs the data "11". If the first result received is "fail", and the second result and the third result are "pass", the decoding unit 614 outputs the data "10". If the first result and the second result received are "fail", and the third result is "pass", the decoding unit 614 outputs the data "01". If the three results received are all "fail", the decoding unit 614 outputs the data "00".

In this embodiment of this application, when the NAND memory 600 simultaneously reads a plurality of pages within the same plane, a time for reading data recorded by a memory cell of each page may be changed, so that the data recorded by the pages is different, the total current of the read circuit varies, and the voltage drop rate of the discharge capacitor C_{SO} varies. When the NAND memory 600 reads the data of the plurality of pages, the voltage comparison unit may be used to detect relationships between the voltages of the discharge capacitor C_{SO} at a plurality of latch time points and the comparison voltage, to accurately read the data recorded by the pages, thereby preventing confusion between the read data and the pages.

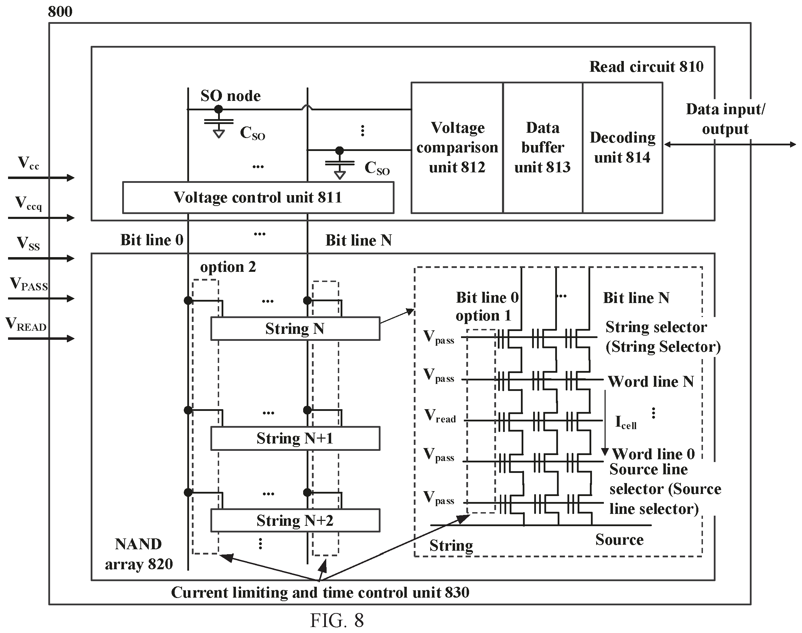

FIG. 8 is a diagram of a structure of a third NAND memory according to an embodiment of this application. As shown in FIG. 8, compared with the structure of the NAND memory 400, in a structure of the NAND memory 800, the current limiting unit 430 is replaced with a current limiting and time control unit 830.

The current limiting and time control unit 830 has functions of the current limiting unit 430 and the time control unit 630, and is configured to limit saturation currents of pages, so that the saturation currents of the pages are different, and configured to stagger discharging times of the pages, so that data of memory cells of the pages is read at different moments.

For example, the NAND memory 800 simultaneously reads data of memory cells of four pages, and the four pages are respectively a page 0, a page 1, a page 2, and a page 3.

The current limiting and time control unit 830 may enable all or some of saturation currents of dual-gate MOS transistors of the memory cells of the four pages to be different, and enable all or some of times for applying a read voltage to the dual-gate MOS transistors of the memory cells of the four pages to be different. For example, the current limiting and time control unit 830 enables the saturation current of the dual-gate MOS transistor of the memory cell of the page 0 to be the same as the saturation current of the dual-gate MOS transistor of the memory cell of the page 1, and enables the saturation current of the dual-gate MOS transistor of the memory cell of the page 2 to be the same as the saturation current of the dual-gate MOS transistor of the memory cell of the page 3, and the current limiting and time control unit 830 enables the saturation current of the dual-gate MOS transistor of the memory cell of the page 0 to be different from the saturation current of the dual-gate MOS transistor of the memory cell of the page 2. The current limiting and time control unit 830 enables the time for applying the read voltage to the dual-gate MOS transistor of the memory cell of the page 0 to be the same as the time for applying the read voltage to the dual-gate MOS transistor of the memory cell of the page 2, enables the time for applying the read voltage to the dual-gate MOS transistor of the memory cell of the page 1 to be the same as the time for applying the read voltage to the dual-gate MOS transistor of the memory cell of the page 3, and enables the time for applying the read voltage to the dual-gate MOS transistor of the memory cell of the page 0 to be different from the time for applying the read voltage to the dual-gate MOS transistor of the memory cell of the page 1. In addition, other cases are not described one by one in this application.

It is assumed that a magnitude relationship between the saturation currents of the dual-gate MOS transistors of the memory cells of the four pages is I_{cell0}>I_{cell1}>I_{cell2}>I_{cell3}, and the times for applying the read voltage to the dual-gate MOS transistors of the memory cells of the four pages differ by a set time T in sequence.

In the evaluate phase, the current limiting and time control unit 830 preferentially enables a string selector in which the page 0 is located to be turned on, and after the set time T, enables a string selector in which the page 1 is located to be turned on. By analogy, until the string selector in which the page 1 is located is turned on.

If the data of the memory cells of the four pages is "1111", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is the saturation current I_{cell3}. Therefore, when the data is "1111", a total current on the read circuit changes sequentially as I_{cell0}, I_{cell0}+I_{cell1}, I_{cell0}+I_{cell1}+I_{cell2}, and I_{cell0}+I_{cell1}+I_{cell2}+I_{cell3}.

If the data of the memory cells of the four pages is "1110", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is 0. Therefore, when the data is "1110", a total current on the read circuit changes sequentially as follows: I_{cell0}, I_{cell0}+I_{cell1}, and I_{cell0}+I_{cell1}+I_{cell2}.

If the data of the memory cells of the four pages is "1101", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is the saturation current I_{cell3}. Therefore, when the data is "1101", a total current on the read circuit changes sequentially as follows: I_{cell0}, I_{cell0}+I_{cell1}, and I_{cell0}+I_{cell1}+I_{cell3}.

If the data of the memory cells of the four pages is "1100", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is 0. Therefore, when the data is "1100", a total current on the read circuit changes sequentially as I_{cell0} and I_{cell0}+I_{cell1}.

If the data of the memory cells of the four pages is "1011", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is the saturation current I_{cell3}. Therefore, when the data is "1011", a total current on the read circuit changes sequentially as follows: I_{cell0}, I_{cell0}+I_{cell2}, and I_{cell0}+I_{cell2}+I_{cell3}.

If the data of the memory cells of the four pages is "1010", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is 0. Therefore, when the data is "1010", a total current on the read circuit changes sequentially as I_{cell0} and I_{cell0}+I_{cell2}.

If the data of the memory cells of the four pages is "1001", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is the saturation current I_{cell3}. Therefore, when the data is "1001", a total current on the read circuit changes sequentially as I_{cell0} and I_{cell0}+I_{cell3}.

If the data of the memory cells of the four pages is "1000", the dual-gate MOS transistor of the memory cell of the page 0 is in an on state and a current flowing through a channel between a source and a drain in the dual-gate MOS transistor is the saturation current I_{cell0}, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is 0. Therefore, when the data is "1000", a total current on the read circuit is always I_{cell0}.

If the data of the memory cells of the four pages is "0111", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is the saturation current I_{cell3}. Therefore, when the data is "0111", a total current on the read circuit changes sequentially as follows: I_{cell1}, I_{cell1}+I_{cell2}, and I_{cell1}+I_{cell2}+I_{cell3}.

If the data of the memory cells of the four pages is "0110", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is 0. Therefore, when the data is "0110", a total current on the read circuit changes sequentially as I_{cell1} and I_{cell1}+I_{cell2}.

If the data of the memory cells of the four pages is "0101", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is the saturation current I_{cell3}. Therefore, when the data is "0101", a total current on the read circuit changes sequentially as I_{cell1} and I_{cell1}+I_{cell3}.

If the data of the memory cells of the four pages is "0100", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is the saturation current I_{cell1}, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is 0. Therefore, when the data is "0100", a total current on the read circuit is always I_{cell2}.

If the data of the memory cells of the four pages is "0011", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is the saturation current I_{cell2}, and the dual-gate MOS transistor of the memory cell of the page 3 is in an on state and a current flowing through a channel between a source and a drain in the dual-gate MOS transistor is the saturation current I_{cell3}. Therefore, when the data is "0011", a total current on the read circuit changes sequentially as I_{cell2} and I_{cell2}+I_{cell3}.

If the data of the memory cells of the four pages is "0001", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is the saturation current I_{cell3}. Therefore, when the data is "0001", a total current on the read circuit is always I_{cell3}.

If the data of the memory cells of the four pages is "0000", the dual-gate MOS transistor of the memory cell of the page 0 is in an on state and a current flowing through a channel between a source and a drain in the dual-gate MOS transistor is 0, the dual-gate MOS transistor of the memory cell of the page 1 is in an on state and a current flowing through a channel between a source and a drain in the dual-gate MOS transistor is 0, the dual-gate MOS transistor of the memory cell of the page 2 is in an on state and a current flowing through a channel between a source and a drain in the dual-gate MOS transistor is 0, and the dual-gate MOS transistor of the memory cell of the page 3 is in an on state and a current flowing through a channel between a source and a drain in the dual-gate MOS transistor is 0. Therefore, when the data is "0000", a total current on the read circuit is always 0.

When the total current on the read circuit varies, a decreasing slope of a voltage of the discharge capacitor C_{SO} from a voltage V_{SO} to a comparison voltage V_{THSA} varies. A larger total current indicates a larger voltage change slope of the discharge capacitor C_{SO}. The voltage comparison unit 812 may detect comparison results of a plurality of latch time points, and input a plurality of comparison results to the data buffer unit 813. The data buffer unit 813 temporarily buffers the data that is read from the NAND array 820 by the NAND memory 800, to subsequently transmit the read data to a host or a processor. The decoding unit 814 may read the comparison results of the voltage comparison unit 812 buffered by the data buffer unit 813, and analyze, based on the comparison results, that the data of the pages is "0" or "1".

In this embodiment of this application, when the NAND memory 800 simultaneously reads a plurality of pages within the same plane, a saturation current of a dual-gate MOS transistor of a memory cell of each page may be changed, so that the saturation currents of the pages are different, and a time for reading data recorded by the memory cell of each page may be changed, so that the data recorded by the pages is different, the total current of the read circuit varies, and the voltage drop rate of the discharge capacitor C_{SO} varies. When the NAND memory 800 reads the data of the plurality of pages, the voltage comparison unit may be used to detect relationships between the voltages of the discharge capacitor C_{SO} at a plurality of latch time points and the comparison voltage, to accurately read the data recorded by the pages, thereby preventing confusion between the read data and the pages.

An embodiment of this application provides a memory. The memory includes a circuit board and at least one NAND memory. The NAND memory is electrically fastened to the circuit board, and is configured to store data. The NAND memory may be a NAND memory shown in FIG. 4 to FIG. 8. Because the memory includes the NAND memory shown in FIG. 4 to FIG. 8, the memory has all or at least some advantages of the NAND memory. The memory may be an SSD, a USB flash drive, a memory card, a mobile device, or the like.

An embodiment of this application provides an electronic device. The electronic device includes at least one memory and at least one processor. The at least one processor is electrically connected to the at least one memory and configured to write data to the at least one memory and/or read data from the at least one memory. Because the memory includes the NAND memory shown in FIG. 4 to FIG. 8, the electronic device has all or at least some advantages of the NAND memory. The electronic device may be a smartphone, a notebook computer, a tablet computer, a desktop computer, a server, a storage system, a base station, an unmanned aerial vehicle, an outdoor cabinet, or the like.

A quantity of components, a location relationship between the components, types of the components, shapes of the components, and the like of the memory provided in embodiments of this application are not limited to the foregoing embodiment. All technical solutions implemented based on a principle of this application fall within the protection scope of this solution. For any one or more embodiments or figures in the specification, technical solutions combined in a proper manner fall within the protection scope of this solution.

A quantity of components, a location relationship between the components, types of the components, shapes of the components, and the like of the electronic device provided in embodiments of this application are not limited to the foregoing embodiment. All technical solutions implemented based on a principle of this application fall within the protection scope of this solution. For any one or more embodiments or figures in the specification, technical solutions combined in a proper manner fall within the protection scope of this solution.

Finally, it is noted that the foregoing embodiments are merely used to describe the technical solutions of this application. A person of ordinary skill in the art should understand that, although this application is described in detail with reference to the foregoing embodiments, the technical solutions described in the foregoing embodiments may still be modified, or some technical features thereof may be equivalently replaced. Such modifications or replacements do not make the essence of the corresponding technical solutions depart from the spirit and scope of the technical solutions of embodiments of this application.

## Claims

1. A NAND memory (400, 600, 800), comprising:
a voltage control unit (411, 611, 811), comprising a plurality of first output ports and a plurality of second output ports, wherein the plurality of first output ports are all configured to output a first electrical signal, and the plurality of second output ports are all configured to output a second electrical signal;
a NAND array (420, 620, 820), comprising a plurality of strings, wherein each string comprises a plurality of pages, and the plurality of pages are electrically connected to the plurality of first output ports respectively and configured to read or write data when the first electrical signal is received;
an asynchronous unit (430, 630, 830), electrically connected between the plurality of first output ports and the plurality of strings, or electrically connected to gates of string selectors in a plurality of pages of the plurality of strings and gates of dual-gate MOS transistors in the plurality of pages of the plurality of strings, configured to, when data of target dual-gate MOS transistors of the plurality of pages is simultaneously read, cause saturation currents of the target dual-gate MOS transistors of the plurality of simultaneously read pages to be different, and/or cause conduction times of respective pages among the plurality of simultaneously read pages to be different;
a plurality of discharge capacitors (C_{SO}), wherein first terminals of the plurality of discharge capacitors are electrically connected to the plurality of second output ports respectively, and second terminals of the plurality of discharge capacitors are grounded; and
a voltage comparison unit (412, 612, 812), comprising a plurality of input ports, wherein the plurality of input ports are electrically connected to the plurality of second output ports respectively, configured to compare voltages received at the plurality of input ports with a comparison voltage and output comparison results.

2. The NAND memory according to claim 1, wherein the discharge capacitor is in a discharging state when data recorded by a target dual-gate MOS transistor of a page electrically connected to the discharge capacitor is "1"; and the discharge capacitor is in a charging state when the data recorded by the target dual-gate MOS transistor of the page electrically connected to the discharge capacitor is "0".

3. The NAND memory according to claim 1 or 2, wherein the voltage comparison unit is specifically configured to compare voltages received at the plurality of input ports at a plurality of latch (latch) time points with the comparison voltage to obtain a plurality of output sub-results; and
the NAND memory further comprises:
a decoding unit (414, 614, 814), configured to compare the plurality of output sub-results with a preset result, and determine whether data recorded by the target dual-gate MOS transistors of the respective pages among the plurality of simultaneously read pages is "0" or "1", wherein the preset result records correspondences between output sub-results at different latch time points and data recorded by a plurality of simultaneously read target dual-gate MOS transistors.

4. The NAND memory according to claim 3, wherein a relationship between a quantity M of the plurality of latch time points and a quantity N of simultaneously read pages is: M≥(2^{N}-1); and M and N are positive integers greater than or equal to 2.

5. The NAND memory according to claim 3 or 4, wherein there is at least one latch time point between different discharge durations, and the discharge duration refers to a duration for a voltage of a discharge capacitor electrically connected to the target dual-gate MOS transistors of the plurality of simultaneously read pages to decrease to the comparison voltage.

6. The NAND memory according to any one of claims 1 to 5, wherein when the conduction times of the respective pages among the plurality of simultaneously read pages are different, a time difference between conduction times of two adjacent pages is less than or equal to a duration for which the voltage of the discharge capacitor decreases to the comparison voltage.

7. The NAND memory according to any one of claims 1 to 6, wherein the voltage control unit is further configured to: when stopping output of the first electrical signal and the second electrical signal, electrically connect the plurality of first output ports to the plurality of second output ports respectively.

8. The NAND memory according to claim 7, wherein the voltage control unit is further configured to convert a current at the second output ports from a first value to a second value.

9. A memory, comprising:
a circuit board; and
at least one NAND memory according to any one of claims 1 to 8, wherein the NAND memory is electrically fastened to the circuit board, and is configured to store data.

10. An electronic device, comprising:
at least one memory according to claim 9; and
at least one processor, wherein the processor is electrically connected to the at least one memory and configured to write data to the at least one memory and/or read data from the at least one memory.
